(19) **Europäisches Patentamt / European Patent Office / Office européen des brevets**

(11) **EP 2 648 332 B1**

(12) **FASCICULE DE BREVET EUROPEEN**

(45) Date de publication et mention de la délivrance du brevet:
**23.02.2022 Bulletin 2022/08**

(21) Numéro de dépôt: **13161868.8**

(22) Date de dépôt: **29.03.2013**

(51) Classification Internationale des Brevets (IPC):
**H03F 1/02** (2006.01)  **H03F 3/68** (2006.01)
**H03K 19/00** (2006.01)  **H03F 3/21** (2006.01)

(52) Classification Coopérative des Brevets (CPC):
**H03F 1/0205; H03F 3/68**

(54) **Dispositif de polarisation de préamplificateurs**

Vorrichtung zum Polarisieren von Vorverstärkern

Pre-amplifier polarisation device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.04.2012 FR 1253031**

(43) Date de publication de la demande:
**09.10.2013 Bulletin 2013/41**

(73) Titulaire: **Commissariat à l'Énergie Atomique et aux Énergies Alternatives 75015 Paris (FR)**

(72) Inventeur: **Lugiez, Francis 92220 Bagneux (FR)**

(74) Mandataire: **Lebkiri, Alexandre Cabinet Camus Lebkiri 25, Rue de Maubeuge 75009 Paris (FR)**

(56) Documents cités:
| | |
|---|---|
| GB-A- 2 340 684 | JP-A- H05 136 681 |
| US-A- 4 430 582 | US-A- 5 345 266 |
| US-A- 6 147 550 | US-A1- 2005 068 439 |
| US-A1- 2008 129 348 | |

**Description**

**DOMAINE TECHNIQUE DE L'INVENTION**

Le domaine technique de l'invention revendiquée est celui des circuits intégrés multicanaux, notamment en technologie CMOS ou BiCMOS, dédiés à la lecture de capteurs. L'invention revendiquée concerne un dispositif électronique de lecture d'au moins six canaux d'acquisition.

**ARRIERE PLAN TECHNOLOGIQUE DE L'INVENTION**

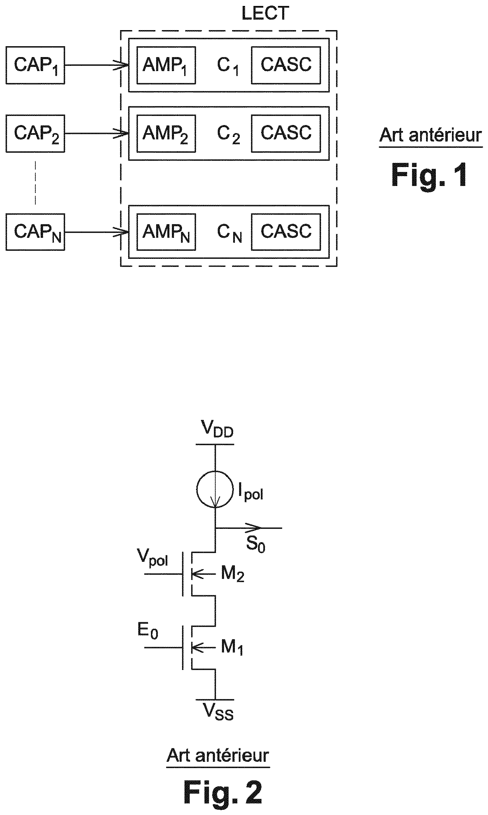

De manière classique, au sein d'un dispositif de lecture de canaux d'acquisition en microélectronique, un préamplificateur est placé en entrée de chaque canal d'acquisition associé à un capteur délivrant un signal électrique. La préamplification permet d'augmenter la puissance des signaux électriques délivrés par les capteurs. Comme le montre la figure 1, pour un dispositif LECT de lecture de N canaux d'acquisition $C_1$, $C_2$, ... $C_N$, dédiés à la lecture de N capteurs $CAP_1$, $CAP_2$, ... $CAP_N$, on trouve donc classiquement N préamplificateurs $AMP_1$, $AMP_2$, ... $AMP_N$, identiques d'un canal à l'autre. L'étage d'entrée de chaque préamplificateur est généralement suivi d'un étage cascode CASC pour augmenter le gain en boucle ouverte et augmenter la dynamique de sortie.

Un préamplificateur classique comporte un élément actif, généralement cascodé. La figure 2 montre un exemple d'un préamplificateur comportant un élément actif $M_1$ polarisé en courant par une source de courant délivrant un courant $I_{pol}$, suivi d'un étage cascode $M_2$ polarisé en tension par une tension de polarisation $V_{pol}$, l'ensemble étant alimenté entre une première tension $V_{SS}$ et une deuxième tension $V_{DD}$. Le signal à préamplifier est appliqué à l'élément actif $M_1$ au niveau d'une entrée $E_0$, et en ressort amplifié au niveau d'une sortie $S_0$.

Cependant un préamplificateur à base d'inverseur CMOS présente des avantages par rapport au préamplificateur classique précédemment décrit, notamment sa transconductance double pour un même courant de polarisation, ce qui est avantageux en termes de bruit : le bruit équivalent en entrée est réduit dans le cas de l'inverseur pour un même courant de polarisation.

Les montages inverseurs CMOS sont ainsi largement utilisés dans les circuits logiques et pour des applications analogiques. La principale difficulté d'utilisation d'un inverseur CMOS pour les applications analogiques est le contrôle du courant de polarisation, car contrairement aux applications logiques où le courant de polarisation statique est nul et où les transistors ne sont activés qu'au moment d'un changement d'état logique, il est nécessaire d'imposer un courant de polarisation facilement contrôlable pour fixer la transconductance du transistor PMOS et du transistor NMOS en fonction des caractéristiques de vitesse et de bruit souhaitées.

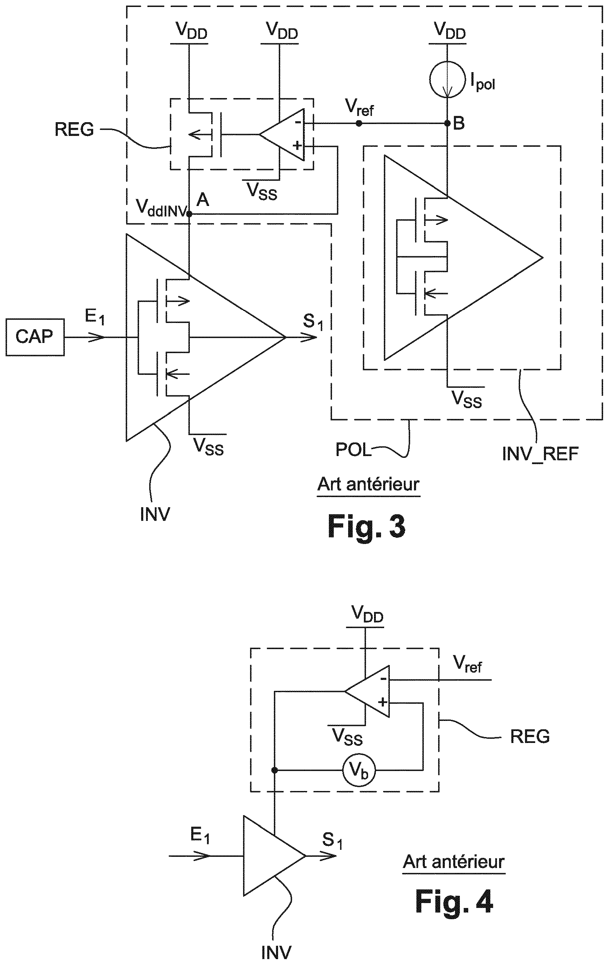

Pour de telles applications analogiques, l'utilisation d'un dispositif de polarisation comportant un régulateur de tension, avec pour référence un inverseur identique dont le courant est imposé, résout cette difficulté. Un tel dispositif de polarisation POL est décrit dans une publication d'Eric Vittoz : « CMOS et BiCMOS VLSI Design'91 », et est illustré dans la figure 3. Le signal d'un capteur CAP à préamplifier est appliqué à un inverseur INV de technologie CMOS, au niveau d'une entrée $E_1$, et en ressort amplifié au niveau d'une sortie $S_1$. Un régulateur de tension REG dont l'étage amplificateur est installé en parallèle de l'inverseur INV, est relié à un inverseur de référence INV_REF identique à l'inverseur INV. Dans cet inverseur de référence INV_REF circule un courant $I_{pol}$ imposé par une source de courant. L'inverseur de référence INV_REF et le régulateur de tension REG, sont alimentés entre une première tension $V_{DD}$ et une deuxième tension $V_{SS}$. L'inverseur de référence INV_REF étant parcouru par un courant connu $I_{pol}$, on obtient une tension de référence $V_{ref}$ à un point B, qui est le point de jonction entre l'inverseur de référence INV_REF et l'entrée de référence du régulateur de tension REG. L'application d'une tension régulée égale à $V_{ref}$ à l'inverseur INV à un point A, qui est le point de jonction entre l'inverseur INV et le régulateur de tension REG, permet d'imposer un courant traversant l'inverseur INV égal à $I_{pol}$. Par ailleurs, le régulateur de tension REG sert à garantir une basse impédance au point A, pour obtenir une bonne réjection des variations de la tension d'alimentation $V_{DD}$. Une telle régulation apporte donc une solution pour contrôler efficacement et de manière robuste le courant statique de polarisation de l'inverseur INV.

L'inconvénient de cette solution vient du bruit inévitable apporté par le régulateur de tension REG intégré, par rapport à une source de tension externe. En effet, on pourrait réduire le bruit d'une source de tension externe par des filtrages à l'aide de capacités externes de forte valeur, mais ceci n'est pas possible dans le volume d'un circuit intégré. Une solution évidente pour réduire le bruit de la régulation est d'augmenter la puissance dissipée dans l'élément amplificateur du régulateur de tension REG, car en augmentant les courants de polarisation des éléments actifs bruyants, leur bruit équivalent en entrée diminue.

La situation devient donc paradoxale : pour profiter d'une réduction potentielle du bruit en entrée apporté par l'inverseur INV pour un même courant de polarisation, par rapport à un préamplificateur classique tel que celui de la figure 2, il faut dissiper une puissance supplémentaire dans le régulateur de tension REG.

Les contributions en bruit de la structure comportant l'inverseur INV et le régulateur de tension REG, et les contributions en bruit d'un préamplificateur classique formé d'un élément actif, sont comparées ci-après. La figure 4 propose un schéma simplifié du montage de la figure 3, pour déterminer la contribution en bruit du régulateur de tension REG. Le bruit intrinsèque du régulateur de tension REG est représenté par une source de bruit équivalente $V_b$, d'où il découle : $V_{ddINV} = V_b + V_{ref}$.

On note que le bruit apporté par l'inverseur de référence INV_REF est négligé car il est aisé de le filtrer soit en interne, soit par une capacité externe. La contribution en bruit de l'inverseur de référence INV_REF est donc considérée comme nulle dans la suite de la description.

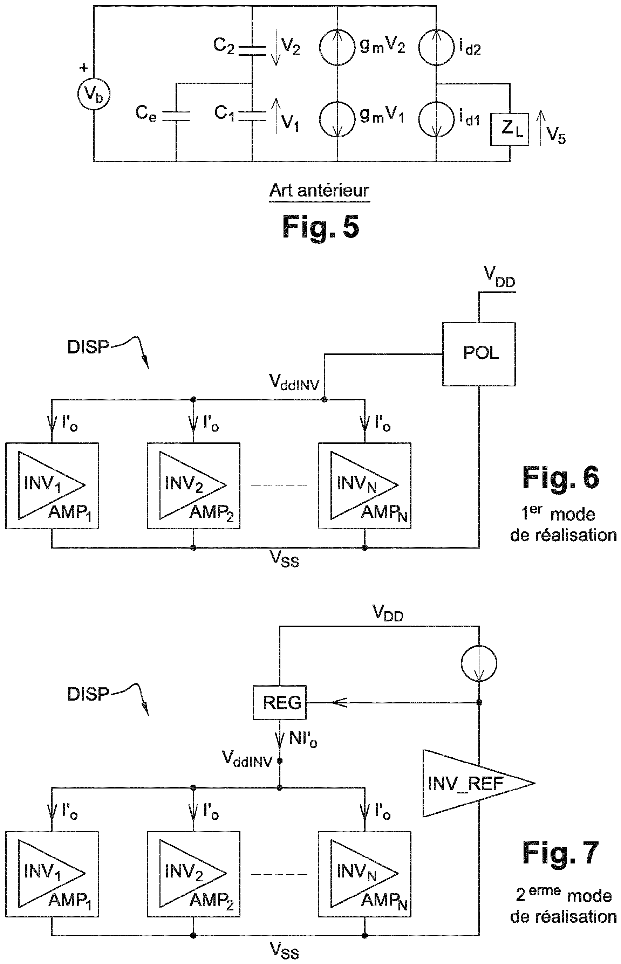

La figure 5 montre un schéma équivalent petit signal du montage de la figure 4. La capacité du capteur CAP dont le signal est préamplifié par l'inverseur INV est notée $C_e$, les capacités des transistors N-MOS et P-MOS sont notées respectivement $C_1$ et $C_2$, les transconductances des transistors N-MOS et P-MOS sont notées $g_{mINV}$ et la charge est notée $Z_L$. $i_{d1}$ et $i_{d2}$ sont les représentations sous forme de sources de courant, des bruits introduits par le N-MOS et le P-MOS.

Le bruit apporté par le régulateur de tension REG ramené en entrée de l'inverseur INV dépend de l'impédance du capteur CAP. Dans le cas d'un capteur CAP du type source de courant à forte impédance interne de nature capacitive, par exemple un détecteur de particule (photon ou particule chargée), la contribution en densité spectrale de bruit (en $V^2$/Hz) du régulateur de tension REG est :

$$V_s = V_b Z_L g_{mINV} \frac{C_e + C_1 - C_2}{C_e + C_1 + C_2}.$$

Le bruit équivalent en entrée est :

$$V_e = \frac{V_s}{2 Z_L g_{mINV}} = \frac{V_b}{2} \frac{C_e + C_1 - C_2}{C_e + C_1 + C_2}$$

(car le gain en tension est $2 Z_L g_{mINV}$).

En prenant des hypothèses réalistes telles : $C_e \gg C_1, C_2$, il vient :

$$V_e = \frac{V_b^2}{4}.$$

D'autre part, le bruit dû à l'inverseur INV ramené en entrée est : $V_{INV} = \frac{2kT\gamma}{g_{mINV}}$ (où $g_{mINV}$ est la transconductance de chaque transconductance de l'inverseur INV) car la densité spectrale de courant de bruit de chaque transistor de l'inverseur INV est $I_d^2 = 4kT\gamma g_{mINV}$.

$$V_{ELT} = \frac{4kT\gamma}{g_{mINV}}.$$

Pour conserver un avantage par rapport à un préamplificateur classique, la condition suivante doit donc être réalisée :

$$\frac{V_b^2}{4} + \frac{2kT\gamma}{g_{mINV}} \le \frac{4kT\gamma}{g_{mINV}},$$

soit

$$\frac{V_b^2}{4} \le \frac{2kT\gamma}{g_{mINV}}.$$

$$V_b{}^2 = \frac{4kT\gamma}{g_{mREG}}$$

Or , $g_{mREG}$ étant la transconductance des éléments actifs formant l'élément amplificateur du régulateur de tension REG.

Pour conserver un avantage par rapport à un préamplificateur classique, la condition à réaliser est donc :

$$g_{mINV} \leq 2.g_{mREG}.$$

Le courant dans l'élément amplificateur du régulateur doit donc être au moins égal à celui de l'inverseur pour remplir cette condition dans la situation habituelle où cet amplificateur est basé sur une paire différentielle.

Il en découle que pour conserver une performance en bruit au moins égale à celle obtenue avec un préamplificateur classique à un élément actif, l'utilisation du montage inverseur avec régulation intégrée amène à doubler le courant dissipé, donc la puissance dissipée. Ceci n'est plus une amélioration mais une détérioration de l'efficacité énergétique et le rapport de signal à bruit obtenu avec une puissance donnée est inférieur à celui obtenu avec un préamplificateur classique.

Le document US 4430582 intitulé « Fast CMOS buffer for TTL input levels » divulgue un circuit de régulation de la tension d'alimentation d'un circuit intégré, le document GB 2340684 intitulé « A CMOS inverter with a process, voltage and temperature-insensitive switching threshold voltage » divulgue un dispositif de polarisation et le document JP H05136681 intitulé « Signal input circuit » divulgue un dispositif électronique d'amélioration de la marge de fonctionnement d'un circuit intégré. Le document US 5345266A intitulé "Matrix array image sensor chip" divulgue un dispositif de lecture de canaux d'acquisition. Le document US 6147550A intitulé "Methods and apparatus for reliably determining subthreshold current densities in transconducting cells" divulgue des dispositifs de polarisation pour des inverseurs.

## DESCRIPTION GENERALE DE L'INVENTION

L'objet de l'invention revendiquée propose une solution pour polariser, ou réguler, des préamplificateurs à base d'inverseurs au sein d'un dispositif électronique de lecture de canaux d'acquisition, en minimisant son impact sur le rapport signal à bruit, dans le cadre d'applications analogiques.

Selon un premier aspect, l'invention concerne un dispositif électronique de lecture d'au moins six canaux d'acquisitions, tel que revendiqué dans la revendication 1.

L'invention revendiquée est utilisable dans le cadre d'applications logiques ou analogiques mais est particulièrement avantageuse dans le cas d'applications analogiques. En effet, dans le cas d'applications analogiques, grâce au dispositif selon l'invention revendiquée, la régulation est moins bruyante car le dispositif de polarisation est mutualisé à plusieurs préamplificateurs, donc sa part de bruit rapportée à un canal s'en trouve diminuée.

L'invention revendiquée est particulièrement adaptée à des préamplificateurs de charge, qui seront décrits par la suite. Les préamplificateurs de charge sont en effet largement utilisés pour des applications analogiques.

Outre les caractéristiques principales qui viennent d'être mentionnées dans le paragraphe précédent, le dispositif selon l'invention peut présenter une ou plusieurs caractéristiques complémentaires telles que revendiquées dans les revendications dépendantes.

De plus:

- le dispositif de polarisation comporte un régulateur de tension et un inverseur de référence, ledit inverseur de référence étant identique aux inverseurs des préamplificateurs. Ceci est une manière simple de réguler à la fois en tension et en courant des préamplificateurs à base d'inverseurs.
- le dispositif de polarisation peut être monté en parallèle des préamplificateurs.

Ainsi, le dispositif de polarisation peut consommer un courant suffisant pour diminuer son bruit propre.

- le dispositif de polarisation est commun à au moins six préamplificateurs. Ceci est la condition à laquelle il est plus avantageux en termes de puissance dissipée et de rapport signal à bruit, d'utiliser des préamplificateurs à base d'inverseurs, polarisés via le dispositif de polarisation, plutôt que des préamplificateurs classiques.

- le régulateur de tension est monté en série avec l'ensemble comportant les préamplificateurs. Ainsi, il n'y a pas de courant dérivé dans le régulateur de tension, donc pas d'augmentation de puissance dissipée et le courant disponible dans l'élément amplificateur du régulateur peut être égal à la somme des courants de polarisation des préamplificateurs, réduisant d'autant le bruit de ce régulateur.

- les inverseurs peuvent être réalisés en technologie CMOS. Les avantages de la technologie CMOS sont connus : faible coût de fabrication, densité d'intégration élevée, accès à des fonctions logiques intégrées pour la réalisation de circuits mixtes analogiques/numériques.

- les inverseurs peuvent être réalisés à l'aide de transistors bipolaires complémentaires issus d'une technologie BiCMOS. Les avantages de la technologie BiCMOS sont connus : ils combinent les avantages de la technologie CMOS et de la technologie bipolaire, utiles pour la réalisation de circuits rapides.

L'invention revendiquée et ses différentes applications seront mieux comprises à la lecture de la description qui suit et à l'examen des figures qui l'accompagnent.

## BREVE DESCRIPTION DES FIGURES

Les figures ne sont présentées qu'à titre indicatif et nullement limitatif de l'invention revendiquée.

Les figures montrent :

- à la figure 1, déjà décrite et représentant l'art antérieur, un dispositif de lecture de canaux d'acquisition ;
- à la figure 2, déjà décrite et représentant l'art antérieur, un préamplificateur classique comportant un élément actif ;
- à la figure 3, déjà décrite et représentant l'art antérieur, un dispositif de régulation pour un préamplificateur à base d'inverseur CMOS ;
- à la figure 4, déjà décrite et représentant l'art antérieur, une représentation simplifiée du montage de la figure 3 ;
- à la figure 5, déjà décrite et représentant l'art antérieur, un schéma équivalent petit signal du montage de la figure 4 ;
- à la figure 6, un dispositif de polarisation d'une pluralité de préamplificateurs à base d'inverseurs, appartenant à un dispositif de lecture de canaux d'acquisition, selon un mode de réalisation non couvert par l'invention revendiquée et uniquement présent à titre illustratif;
- à la figure 7, un dispositif de polarisation d'une pluralité de préamplificateurs à base d'inverseurs, appartenant à un dispositif de lecture de canaux d'acquisition, selon un mode de réalisation de l'invention revendiquée;
- à la figure 8, un préamplificateur de charge qui est utilisé dans l'invention revendiquée.

## DESCRIPTION DETAILLEE D'AU MOINS UN MODE DE REALISATION DE L'INVENTION

Une partie d'un dispositif de lecture DISP de N canaux d'acquisition selon un premier mode de réalisation non couvert par l'invention revendiquée et uniquement présent à titre illustratif, est représentée à la figure 6. Le dispositif de lecture DISP comporte :

- N préamplificateurs $AMP_i$, chaque préamplificateur $AMP_i$ étant installé en sortie d'un capteur non représenté, et en entrée d'un canal d'acquisition non représenté. Un préamplificateur $AMP_i$ correspond donc à un capteur et à un canal d'acquisition. Chaque préamplificateur $AMP_i$ comporte un inverseur $INV_i$.
- Un dispositif de polarisation POL tel que celui décrit précédemment, et représenté à la figure 3, comportant :

  o Un régulateur de tension REG
  ◦ Un inverseur de référence INV_REF
  ◦ Une source de courant $I_{pol}$

Dans ce premier mode de réalisation, le régulateur de tension REG et l'inverseur de référence INV_REF, sont alimentés entre une première tension $V_{DD}$ et une deuxième tension $V_{SS}$. La tension appliquée aux préamplificateurs $AMP_i$ grâce au dispositif de polarisation est $V_{ddINV}$, comme expliqué précédemment. On note que dans ce premier mode de réalisation, le dispositif de polarisation POL est monté en parallèle sur les préamplificateurs $AMP_i$.

A partir des calculs précédents permettant de comparer un préamplificateur classique à un ensemble amplificateur à base d'inverseur avec régulateur, une généralisation à l'ensemble des N inverseurs $INV_i$ associés à un seul dispositif de polarisation POL, en conservant une même puissance allouée par canal $P_0$, est réalisée ci-après.

Dans les expressions qui suivent, la notation $g_m(I)$ signifie que la transconductance $g_m$ d'un transistor est fonction du courant de polarisation I qui le traverse.

Pour un préamplificateur classique :

- la puissance dissipée est $P_0$, correspondant à un courant de polarisation $I_0$. On a $P_0 = I_0 \cdot (V_{DD} - V_{SS})$.

- la densité spectrale de bruit ramenée en entrée vaut $\dfrac{4kT\gamma}{g_m(I_0)}$ .

Pour les N préamplificateurs $AMP_i$ à base d'inverseurs $INV_i$, avec le dispositif de polarisation POL :

- la puissance dissipée est : $NP_0 = NP_0' + P_{REG}$, avec $P_0' = I_0'.(V_{DD} - V_{SS})$, $I_0'$ étant le courant de polarisation qui parcourt un préamplificateur $AMP_i$, et $P_{REG} = I_{REG}.(V_{DD} - V_{SS})$ étant la puissance consommée par l'élément amplificateur du régulateur de tension REG ;
- la densité spectrale de bruit ramenée en entrée vaut :

$$\frac{2kT\gamma}{g_m(I_0')} + \frac{V_b^2}{4} = \frac{2kT\gamma}{g_m(I_0')} + \frac{kT\gamma}{g_m(\frac{I_{REG}}{2})}$$

car l'élément amplificateur du régulateur de tension REG étant un amplificateur différentiel, le courant disponible par élément actif est $\dfrac{I_{REG}}{2}$ .

On note que pour les mêmes raisons que précédemment, la contribution en bruit de l'inverseur de référence INV_REF est donc considérée comme nulle.

Pour conserver un avantage par rapport à un préamplificateur classique, il faut donc réaliser la condition :

$$\frac{2kT\gamma}{g_m(I_0')} + \frac{kT\gamma}{g_m(\frac{I_{REG}}{2})} \leq \frac{4kT\gamma}{g_m(I_0')}, \text{ soit } \frac{2}{g_m(I_0')} + \frac{1}{g_m(\frac{I_{REG}}{2})} \leq \frac{4}{g_m(I_0)}$$

Dans le cas de transistors bipolaires ou de transistors MOS en faible inversion, cette inéquation peut être résolue analytiquement car les transconductances $g_m$ sont proportionnelles aux courants, donc aux puissances. La condition devient, en tenant compte du fait que $N.I_0 = NI_0' + I_{REG}$, puisqu'on ne veut pas dissiper plus de puissance :

$$\frac{2I_0'}{I_0} + \frac{I_0}{I_0'} \leq 3 - \frac{1}{N} \text{ avec } \frac{I_0}{I_0'} > 1$$

, où I0 est le courant traversant un préamplificateur classique, et $I_0'$ est le courant traversant un préamplificateur $AMP_i$ à base d'inverseur $INV_i$.

La quantité $\dfrac{2I_0'}{I_0} + \dfrac{I_0}{I_0'}$ est minimale lorsque $\dfrac{I_0}{I_0'} = \sqrt{2}$ . Pour cette valeur $\dfrac{I_0}{I_0'} = \sqrt{2}$ , on obtient alors la plus petite valeur de N satisfaisant l'inégalité, ce qui conduit à $N \geq 6$. Le bruit de l'inverseur, en valeur efficace, est alors 84% du bruit du préamplificateur classique avec la même consommation apparente. La valeur limite du bruit en conservant la même consommation apparente par canal, quand N augmente, est 71% $71\% \left(\dfrac{1}{\sqrt{2}}\right)$ . Si l'on souhaite limiter la puissance en conservant le même bruit qu'avec une architecture classique, on obtient un gain de 50% sur la puissance consommée.

Un mode de réalisation de l'invention revendiquée est représenté sur la figure 7. Si l'inverseur de référence INV_REF est toujours alimenté entre la première tension $V_{DD}$ et la deuxième tension $V_{SS}$, le régulateur de tension REG est, lui, alimenté entre la première tension $V_{DD}$ et la tension $V_{ddINV}$. Ainsi, le régulateur de tension REG est alimenté en série avec les préamplificateurs $AMP_i$, il n'y a donc pas de courant dérivé dans le régulateur de tension REG. Le courant dérivé dans l'inverseur de référence INV_REF est quant à lui très faible, on le négligera. Le courant disponible dans le régulateur de tension REG est alors $N.I_0'$.

A puissance égale, le bruit du montage décrit à base d'inverseurs, par rapport au bruit de l'architecture classique

est : $\dfrac{V_b(INV)}{V_b(classique)} = \dfrac{\sqrt{1+\dfrac{1}{N}}}{\sqrt{2}}$ , ce qui tend rapidement vers $70\%$ $\left(\dfrac{1}{\sqrt{2}}\right)$ , et l'amélioration d'un tel dispositif par rapport à un préamplificateur classique est immédiate à partir de N=2.

L'invention revendiquée propose donc une solution pour polariser des préamplificateurs à base d'inverseurs au sein d'un dispositif électronique de lecture de canaux d'acquisition, sans affecter le rapport signal à bruit. Le même rapport signal à bruit peut être obtenu avec une puissance consommée égale à 50% de celle de l'architecture classique.

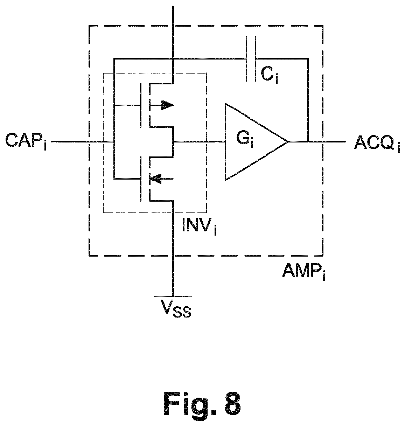

Les N préamplificateurs $AMP_i$ sont des préamplificateurs de charge, bien connus de l'homme du métier. Comme illustré à la figure 8, un préamplificateur de charge $AMP_i$ comporte un premier étage de gain constitué d'un inverseur $INV_i$, un deuxième étage de gain Gi, et un condensateur mémoire $C_i$.

## Revendications

1. - Dispositif (DISP) électronique de lecture d'au moins six canaux d'acquisition, le dispositif comportant :

   - pour chaque canal d'acquisition, un préamplificateur de charge (AMPi), installé en entrée du canal d'acquisition et comportant un premier étage de gain constitué d'un inverseur (INVi) et un condensateur mémoire (Ci), le préamplificateur (AMPi) comportant une entrée configurée pour recevoir un signal d'un capteur (CAP) ; le dispositif (DISP) étant **caractérisé par**:
   - un dispositif de polarisation (REG, INV_REF), ledit dispositif de polarisation étant commun à au moins six préamplificateurs de charge (AMPi) et étant configuré pour délivrer une tension d'alimentation régulée (VddINV) sur une borne

   d'alimentation de chacun des au moins six préamplificateurs de charges (AMPi), ledit dispositif de polarisation comportant :

   - un régulateur de tension (REG), ledit régulateur de tension (REG) comprenant un étage amplificateur ;
   - un inverseur de référence (INV_REF), identique aux inverseurs (INV) desdits au moins six préamplificateurs de charge (AMPi) ; et
   - une source de courant (Ipol) ;

   l'étage amplificateur du régulateur de tension (REG) étant relié à l'inverseur de référence, l'inverseur de référence étant parcouru par un courant imposé par la source de courant, ledit courant étant configuré pour appliquer une tension de référence (Vref) à une entrée de référence du régulateur de tension (REG), le régulateur de tension (REG) étant connecté en série avec un ensemble comprenant lesdits au moins six préamplificateurs de charge (AMPi), le régulateur de tension (REG) étant alimenté entre une première tension (Vdd) et la tension d'alimentation régulée (VddINV), ladite tension d'alimentation régulée (VddINV) étant égale à la tension de référence (Vref).

2. - Dispositif (DISP) selon la revendication précédente, dans lequel le dispositif de polarisation (POL) est monté en parallèle des préamplificateurs (AMPi).

3. - Dispositif (DISP) selon l'une des revendications précédentes, dans lequel chaque préamplificateur de charge (AMPi) comporte un deuxième étage de gain (Gi).

4. - Dispositif (DISP) selon l'une des revendications précédentes, dans lequel l'étage amplificateur du régulateur de tension (REG) est un amplificateur différentiel.

5. - Dispositif selon l'une des revendications précédentes, **caractérisé en ce que** les inverseurs ($INV_i$) sont réalisés en technologie CMOS.

6. - Dispositif selon l'une des revendications précédentes, **caractérisé en ce que** les inverseurs ($INV_i$) sont réalisés en technologie BiCMOS.

**Patentansprüche**

1. Elektronische Lesevorrichtung (DISP) von wenigstens sechs Erfassungskanälen, wobei die Vorrichtung umfasst:

   ▪ für jeden Erfassungskanal einen Last-Vorverstärker (AMPi), der am Eingang des Erfassungskanals eingebaut ist und eine aus einem Stromwender (INVi) und einem Speicherkondensator (Ci) gebildete Verstärkungsetage umfasst, wobei der Vorverstärker (AMPi) einen Eingang umfasst, der zum Empfangen eines Signals eines Sensors (CAP) konfiguriert ist;
   wobei die Vorrichtung (DISP) **gekennzeichnet ist durch**:
   ▪ eine Polarisationsvorrichtung (REG, INV_REF), wobei die genannte Polarisationsvorrichtung wenigstens sechs Last-Vorverstärkern (AMPi) gemeinsam ist und zum Ausgeben einer Versorgungsspannung konfiguriert ist, die auf einer Versorgungsbuchse jedes der wenigstens sechs Last-Vorverstärkern (AMPi) eingestellt (VddINV) ist, wobei die genannte Polarisierungsvorrichtung umfasst:

   - einen Spannungsregler (REG), wobei der genannte Spannungsregler (REG) eine Verstärkungsetage umfasst;
   - einen Bezugsstromwender (INV_REF), der mit den Stromwendern (INV) der genannten wenigstens sechs Last-Vorverstärkern (AM-Pi) identisch ist; und
   - eine Stromquelle (Ipol);

   wobei die Verstärkeretage des Spannungsreglers (REG) mit dem Bezugsstromwender verbunden ist, wobei der Bezugsstromwender **durch** einen Strom durchströmt ist, der von der Stromquelle aufgezwungen ist, wobei der genannte Strom konfiguriert ist, um eine Bezugsspannung (Vref) auf einen Referenzeingang des Spannungsreglers (REG) anzuwenden, wobei der Spannungsregler (REG) in Serie an eine Gruppe angeschlossen ist, die die genannten wenigstens sechs Last-Vorverstärker (AMPi) umfasst, wobei der Spannungsregler (REG) zwischen einer ersten Spannung (Vdd) und der eingestellten Versorgungsspannung (VddINV) versorgt ist, wobei die genannte eingestellte Versorgungsspannung (VddINV) gleich der Bezugsspannung (Vref) ist.

2. Vorrichtung (DISP) gemäß dem voranstehenden Anspruch, bei der die Polarisationsvorrichtung (POL) parallel zu den Vorverstärkern (AMPi) montiert ist.

3. Vorrichtung (DISP) gemäß einem der voranstehenden Ansprüche, bei der jeder Last-Vorverstärker (AMPi) eine zweite Verstärkungsetage (Gi) umfasst.

4. Vorrichtung (DISP) gemäß einem der voranstehenden Ansprüche, bei der die Verstärkeretage des Spannungsreglers (REG) ein Differentialverstärker ist.

5. Vorrichtung gemäß einem der voranstehenden Ansprüche, **dadurch gekennzeichnet, dass** die Stromwender (INVi) nach der Technologie CMOS realisiert sind.

6. Vorrichtung gemäß einem der voranstehenden Ansprüche, **dadurch gekennzeichnet, dass** die Stromwender (INVi) nach der Technologie BiCMOS realisiert sind.

**Claims**

1. - Electronic device (DISP) for reading at least six acquisition channels, the device comprising:

   - for each acquisition channel, a charge preamplifier (AMPi), installed at the input of the acquisition channel and comprising a first gain stage consisting of an inverter (INVi) and a memory condenser (Ci), the preamplifier (AMPi) comprising an input configured to receive a signal from a sensor (CAP) ;

   the device (DISP) being **characterised by** :

   - a biasing device (REG, INV_REF), said biasing device being common to at least six charge preamplifiers (AMPi) and being configured to deliver a regulated supply voltage on a supply terminal of each of the at least six charge preamplifiers (AMPi), said biasing device comprising:

- a voltage regulator (REG), said voltage regulator (REG) comprising an amplifier stage;
- a reference inverter (INV_REF), identical to the inverters (INV) of said at least six charge preamplifiers (AMPi) ; and
- a current source (Ipol) ;

the amplifier stage of the voltage regulator (REG) being connected to the reference inverter, the reference inverter being traversed by a current imposed by the current source, said current being configured to apply a reference voltage (Vref) to a reference input of the voltage regulator (REG), the voltage regulator (REG) being connected in series with a set comprising said at least six charge preamplifiers (AMPi), the voltage regulator (REG) being supplied between a first voltage (Vdd) and the regulated supply voltage (VddINV), said regulated supply voltage (VddINV) being equal to the reference voltage (Vref).

2. - Electronic device (DISP) according to the previous claim, wherein the biasing device (POL) is connected in parallel with the preamplifiers (AMPi).

3. - Electronic device (DISP) according to one of the previous claims, wherein each charge preamplifier (AMPi) comprises a second gain stage (Gi).

4. - Electronic device (DISP) according to one of the previous claims, wherein the amplifier stage of the voltage regulator (REG) is a differential amplifier.

5. - Electronic device according to one of the previous claims, **characterised in that** the inverters (INV$_i$) are based on CMOS technology.

6. - Electronic device according to one of the previous claims, **characterised in that** the inverters (INV$_i$) are based on BiCMOS technology.

LECT

CAP$_1$ → AMP$_1$ C$_1$ CASC

CAP$_2$ → AMP$_2$ C$_2$ CASC

CAP$_N$ → AMP$_N$ C$_N$ CASC

Art antérieur

# Fig. 1

$V_{DD}$

$I_{pol}$

$S_0$

$V_{pol}$ — M$_2$

$E_0$ — M$_1$

$V_{SS}$

Art antérieur

# Fig. 2

V_DD  V_DD  V_DD

REG

V_ref

B

I_pol

V_SS

A

V_ddINV

CAP  E_1  S_1

V_SS

POL  INV_REF

INV

V_SS

Art antérieur

## Fig. 3

V_DD

V_ref

V_SS

REG

V_b

E_1  S_1

INV

Art antérieur

## Fig. 4

Art antérieur

**Fig. 5**

**Fig. 6**

$1^{er}$ mode
de réalisation

**Fig. 7**

$2^{erme}$ mode
de réalisation

**Fig. 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4430582 A
- GB 2340684 A
- JP H05136681 B
- US 5345266 A
- US 6147550 A